# EUROPÄISCHE PATENTANMELDUNG

(11) **EP 4 570 967 A1**
(43) Veröffentlichungstag der Anmeldung: **18.06.2025**
(21) Anmeldenummer: 23215655.4
(22) Anmeldetag: 11.12.2023
(51) Int. Cl.: C30B 15/20, C30B 15/30

(54) **VORRICHTUNG ZUR REDUZIERUNG VON PENDELAUSLENKUNGEN WÄHREND EINES KRISTALLZIEHPROZESSES**

(71) Anmelder: Siltronic AG, 81677 München (DE)
(72) Erfinder: Huber, Johann-Andreas, 83404 Ainring (DE)
(74) Vertreter: Hasenhütl, Eva

(57) **Zusammenfassung**

Die Erfindung betrifft eine Pendelauslenkungsreduzierungsvorrichtung (200) umfassend zwei Piezoelementeinheiten (201, 202) und eine Steuereinheit, welche dazu ausgebildet sind und derart mit einer Umlenkrolle (10) eines Seildrehkopfs einer Kristallziehvorrichtung während eines Ziehprozesses zusammenwirken, dass über eine gezielte, kommunizierende Ansteuerung der Piezoelementeinheiten (201, 202) über die Steuereinheit unter Ausnutzung des Piezoeffekts zur gezielten Einstellung eines Bewegungsabschnitts der Umlenkrolle (10) einer aktuellen Pendelauslenkung des im Wesentlichen kontinuierlich zu einem Kristallstab wachsenden Kristallstababschnitts entgegengewirkt wird.

## Beschreibung

### Technisches Gebiet

Die Erfindung betrifft eine Vorrichtung zur Reduzierung von Pendelauslenkungen während eines Kristallziehprozesses, sowie ein Verfahren zu Herstellung eines Einkristallstabs an einer Kristallziehvorrichtung unter verminderter Pendelauslenkung.

### Stand der Technik und technische Aufgabe

Sofern es beim Ziehprozess eines Kristallstabs an einer Kristallziehvorrichtung (im Folgenden sind unter Kristallziehvorrichtung jene zu verstehen, welche eine Ziehvorrichtung nach Art einer Seilpendelvorrichtung aufweisen) aufgrund eines ungünstigen Verhältnisses der Seillänge zur Kristallrotation kommt, kann es zum sogenannten Orbiting kommen. Dies führt zur Einschränkung von Prozessparametern. Um das Kristallziehen auch innerhalb der Prozessbereichs der Resonanzfrequenz des Systems zu ermöglich, ist eine aktive Gegensteuerung zur Pendelbewegung erforderlich.

Aus dem Stand der Technik ist zur Lösung dieser Problematik eine aktive Regelung an der Kristallziehvorrichtung mittels eines "X-Y-Tisches" (Führungen in 2 Achsen) unterhalb des Seildrehkopfes, wie beispielsweise in DE 102009024472 A1 beschrieben, bekannt. Hierbei wird zur Reduzierung von Pendelauslenkungen während des Ziehprozesses der Seildrehkopf mit dem X-Y-Tisch entsprechend in Querrichtungen (entlang der X-Richtung und Y-Richtung) zur Höhenachse verschoben. Das Vorsehen eines derartigen, verschiebbaren X-Y-Tisches unterhalb des Seildrehkopfes zur Entgegenwirkung von Pendelauslenkungen während des Ziehprozesses erfordert jedoch einen komplexen konstruktiven sowie steuerungstechnischen Aufbau: der X-Y -Tisch ist schwer und stabil ausgeführt, um die Massenkräfte beim Verfahren aufzunehmen. Der motorische Antrieb ist entsprechend auf schnelle Lastwechsel auszuführen.

Der vorliegenden Erfindung liegt daher die objektive, technische Aufgabe zu Grunde, auf einfache Weise insbesondere ein Verfahren sowie eine Vorrichtung zur Herstellung eines Einkristallstabs unter verminderter Pendelauslenkung herzustellen, welche die oben genannten Nachteile nicht oder zumindest in geringerem Ausmaß aufweisen und welche insbesondere ohne dem Vorsehen eines verschiebbaren X-T-Tisches unterhalb eines Seildrehkopfes zur Entgegenwirkung bzw. Reduzierung von Pendelauslenkungen auskommt.

Gelöst wird die Aufgabe gemäß einem ersten Aspekt durch eine Pendelauslenkungsreduzierungsvorrichtung gemäß den Merkmalen nach Anspruch 1, gemäß einem zweiten Aspekt durch eine Kristallziehvorrichtung gemäß den Merkmalen nach Anspruch 4, sowie gemäß einem dritten Aspekt durch ein Verfahren zur Herstellung eines Einkristallstabs unter verminderter Pendelauslenkung gemäß den Merkmalen nach Anspruch 10. Schließlich betrifft die Erfindung ausgehend von dem erfindungsgemäßen Verfahren bzw. seiner bevorzugten Varianten zur Herstellung eines Einkristallstabs unter verminderter Pendelauslenkung die weiterverarbeitende Herstellung von Scheiben aus Halbleitermaterial gemäß Anspruch 11.

### Beschreibung der Erfindung

Der Erfindung liegt hierbei die technische Lehre zugrunde bzw. die Erfindung hat erkannt, dass man auf einfache Weise und insbesondere ohne die eben beschriebenen konstruktiven zusätzlichen Aufbauten an der Kristallziehvorrichtung zur Entgegenwirkung einer Pendelauslenkung einen Kristallstab fertigen kann, welcher unter verminderter Pendelauslenkung an der Kristallziehvorrichtung gezogen wird, indem man eine Reduzierung bzw. Dämpfung, insbesondere im Wesentlichen Kompensation, der zeitlich folgenden Pendelauslenkungen durch die Bereitstellung zweier entsprechend (insbesondere kommunizierend) angesteuerter und entsprechend an geeigneten Stellen der Kristallziehvorrichtung angeordneter Piezoelementeinheiten einer kompakten Pendelauslenkungsreduzierungsvorrichtung vornimmt.

Gemäß einem ersten Aspekt betrifft die Erfindung daher eine Pendelauslenkungsreduzierungsvorrichtung umfassend zwei Piezoelementeinheiten und eine Steuereinheit, welche dazu ausgebildet sind und derart mit einer Umlenkrolle eines Seildrehkopfs einer Kristallziehvorrichtung während eines Ziehprozesses zusammenwirken, dass über eine gezielte, kommunizierende Ansteuerung der Piezoelementeinheiten über die Steuereinheit unter Ausnutzung des Piezoeffekts zur gezielten Einstellung eines Bewegungsabschnitts der Umlenkrolle einer aktuellen Pendelauslenkung, vorzugsweise in Bezug auf eine Kristallpendelruheachse, des im Wesentlichen kontinuierlich zu einem Kristallstab wachsenden Kristallstababschnitts entgegengewirkt wird.

Vorteilhafte Ausgestaltungen der erfindungsgemäßen Pendelauslenkungsreduzierungsvorrichtung ergeben sich aus den weiter unten angegeben bevorzugten Varianten und aus den entsprechenden Unteransprüchen.

Gemäß einem zweiten Aspekt betrifft die Erfindung daher eine Kristallziehvorrichtung zur Herstellung eines Einkristallstabs, umfassend eine Ziehvorrichtung nach Art einer Seilpendelvorrichtung mit einem Seildrehkopf, wobei der Seildrehkopf eine Umlenkrolle umfasst, wobei
- die Kristallziehvorrichtung dazu ausgebildet ist, während wenigstens eines Ziehprozesses einen im Wesentlichen sukzessiv fortschreitenden Einkristallstababschnitt mit einer einhergehenden im Wesentlichen sukzessiv fortschreitenden zugeordneten Einkristalllänge aus einer Schmelze zu dem Einkristallstab zu ziehen, wobei
- die Kristallziehvorrichtung, vorzugsweise durch die Ziehvorrichtung, einen Pendeldrehpunkt definiert, durch welchen im Wesentlichen entlang einer Höhenachse, eine definierte Kristallpendelruheachse verläuft.

Die erfindungsgemäße Kristallziehvorrichtung weist weiterhin eine Pendelauslenkungsreduzierungsvorrichtung auf, welche zwei Piezoelementeinheiten und eine Steuereinheit umfasst, wobei die Pendelauslenkungsreduzierungsvorrichtung dazu ausgebildet ist und derart mit der Umlenkrolle des Seildrehkopfs während eines Ziehprozesses zusammenwirkt, dass über eine gezielte, kommunizierende Ansteuerung der Piezoelementeinheiten über die Steuereinheit unter Ausnutzung des Piezoeffekts zur gezielten Einstellung eines Bewegungsabschnitts der Umlenkrolle einer aktuellen Pendelauslenkung, vorzugsweise in Bezug auf die Kristallpendelruheachse, des im Wesentlichen kontinuierlich zu einem Kristallstab wachsenden Kristallstababschnitts entgegengewirkt wird.

Vorteilhafte Ausgestaltungen der erfindungsgemäßen Kristallziehvorrichtung ergeben sich aus den weiter unten angegeben bevorzugten Varianten und aus den entsprechenden Unteransprüchen.

Gemäß einem dritten Aspekt betrifft die Erfindung ein Verfahren zur Herstellung eines Einkristallstabs an der erfindungsgemäßen Kristallziehvorrichtung (oder an einer ihrer bevorzugten Varianten) unter verminderter Pendelauslenkung während eines Ziehprozesses mittels der erfindungsgemäßen Pendelauslenkungsreduzierungsvorrichtung (oder an einer ihrer bevorzugten Varianten), wobei während des Ziehprozesses ein im Wesentlichen sukzessiv fortschreitenden Einkristallstababschnitt mit einer einhergehenden im Wesentlichen sukzessiv fortschreitenden zugeordneten Einkristalllänge aus einer Schmelze zu dem Einkristallstab gezogen wird.

Schließlich betrifft die Erfindung ein Verfahren zur Herstellung einer Scheibe aus Halbleitermaterial aus einem Einkristallstab, welcher unter verminderter Pendelauslenkung nach dem erfindungsgemäßen Verfahren zur Herstellung eines Einkristallstabs an der erfindungsgemäßen Kristallziehvorrichtung (oder an einer ihrer bevorzugten Varianten) hergestellt wurde, wobei ausgehend von dem Ende des Verfahrens zur Herstellung des Einkristallstabs wenigstens folgende Schritte folgen:
- Sägen des Einkristallstabs in dünne Scheiben,
- Chemische und/oder mechanische Weiterbehandlung wenigstens einer der dünnen Scheiben aus Halbmaterial, wobei die Weiterbehandlung wenigstens einen Weiterbehandlungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, umfasst.

Die Piezoelementeinheiten sind vorzugsweise dazu ausgebildet, beim Zusammenwirken mit einer Kristallziehvorrichtung für die Reduzierung von Pendelauslenkungen durch eine entsprechende Ansteuerung als Motoreinheiten zu wirken, wobei sie hierbei als Kleinmotoren ausgeführt sind, die den piezoelektrischen Effekt zur Erzeugung einer Bewegung nutzen.

Vorzugsweise wirken die Piezoelementeinheiten weiterhin als Lagereinheiten und/oder Führungseinheiten beim Zusammenwirken mit einer Umlenkrolle der Kristallziehvorrichtung, insbesondere mit Lageraufnahmen der Umlenkrolle. Diese Bewegungsmöglichkeit kann nun in vorteilhafter Weise dazu genutzt werden, bei entsprechender Anordnung der Piezoelementeinheiten in der Umgebung der Umlenkrolle (insbesondere symmetrisch zu beiden Seiten der Umlenkrolle in Bezug auf eine Höhenachse der Umlenkrolle beabstandet), konkret diese Umlenkrolle zu bewegen.

Die direkte Bewegung bzw. Ansteuerung der Umlenkrollenposition hat u.a. den Vorteil, dass nicht der ganze Seildrehkopf zur Gegenbewegung bewegt werden muss, sondern eben zielgerichtet nur die Umlenkrolle (welche die Funktion zur Zentrierung des Ziehseils innerhalb der Kristallziehvorrichtung übernimmt) zur Reduzierung der Pendelauslenkung gegenbewegt wird. Durch das Vorsehen einer derartigen Pendelauslenkungsreduzierungsvorrichtung, welche in der Umgebung der Umlenkrolle angeordnet ist und vorzugsweise entsprechend mit ihren Lageraufnahmen zusammenwirkt, hat weiterhin den Vorteil, dass sich die für die Reduzierung der Pendelauslenkung notwendige, zu bewegende Masse für die Gegensteuerung massiv reduziert im Vergleich zu den oben im Stand der Technik angegebenen Ausführungen mit X-Y-Tisch.

Derartige Piezoelementeinheiten als Teil einer Pendelauslenkungsreduzierungsvorrichtung liefern aufgrund ihrer kurzen Reaktionszeit weiterhin den Vorteil einer zügigen Pendelauslenkungsreduzierung. Weiterhin sind die technisch realisierbaren, linearen Bewegungsmöglichkeiten der Piezoelementeinheiten für den konkreten Zweck völlig ausreichend für die Pendelauslenkungen im mm-Bereich und der Gegensteuerung im mm-Bereich. Üblicherweise sind Gegenbewegungen von weniger als 1,5mm, vorzugsweise von weniger 1,0 mm zur Reduzierung von Pendelauslenkungen des Kristallstabs an der Kristallziehvorrichtung erforderlich. Das Vorsehen derartiger Piezoelementeinheiten beansprucht weiterhin in vorteilhafter Weise wenig Bauraum an der Kristallziehvorrichtung.

Die Piezoelementeinheiten sind vorzugsweise symmetrisch zu beiden Seiten der Umlenkrolle beabstandet, jeweils in einer Lageraufnahme der Umlenkrolle, angeordnet.

Hierbei ist vorzugsweise weiterhin jede der Piezoelementeinheiten und jede der Lageraufnahmen entsprechend ausgestaltet, sodass die Bewegung der Umlenkrolle in Form des Bewegungsabschnitts aus der gleichgerichteten Bewegung der Piezoelementeinheiten (und dadurch auch aus der gleichgerichteten Bewegung der Lageraufnahmen der Umlenkrolle) resultiert, wobei die Bewegung der Umlenkrolle (und jeder Lageraufnahme) vorzugsweise über den Antrieb der Piezoelementeinheiten - wirkend als (Piezo-)Motoreinheiten - über eine entsprechende kommunizierende Ansteuerung über eine Steuereinheit der Pendelauslenkungsreduzierungsvorrichtung unter Ausnutzung des (bekannten) Piezoeffekts vorgenommen wird. Dies geschieht vorzugsweise dank ihrer bekannten, äußerst kurzen Reaktionszeiten im Wesentlichen unmittelbar zeitlich folgend auf eine ermittelte aktuelle Pendelauslenkung.

Vorzugsweise sind die Umlenkrolle und die Pendelauslenkungsreduzierungsvorrichtung dazu ausgebildet, dass während des Ziehprozesses in Reaktion auf eine aktuelle Pendelauslenkung eines aktuellen Kristallstababschnitts, und insbesondere in Abhängigkeit der Höhe der aktuellen Pendelauslenkung des aktuellen Kristallstababschnitts, insbesondere bei Überschreiten eines vorgebbaren Auslöseschwellwertes, die Umlenkrolle in einer Richtung entlang einer Achse X eine Bewegung in Form des Bewegungsabschnitts, vorzugsweise mit einem maximalen Betrag eines Bewegungsabschnitts von 1,5 mm, insbesondere 1,0 mm, ausgehend von einer Ruhelage der Umlenkrolle, erfährt, wobei die X-Achse mit der Umlenkrollenrotationsachse zusammenfällt. Vorzugsweise sind die Piezoelementeinheiten derart in den Lageraufnahmen der Umlenkrolle angeordnet, dass eine gedachte Verbindungslinie der Schwerpunkte der beiden Piezoelementeinheiten parallel zur Achse X verläuft. Die Bewegungsachse, auf der die eindimensionale Bewegung der Umlenkrolle zur Reduzierung der Pendelauslenkung verläuft, ist somit eindeutig fix vorgegeben und reduziert somit auf einfache Weise, jedoch auf ausreichend effektive Weise und richtungsunabhängig von der aktuellen Pendelauslenkung die weitere Pendelauslenkung im Ziehprozess.

Vorzugsweise wird die Pendelauslenkungsreduzierungsvorrichtung ab dem Überschreiten eines vorgebbaren Auslöseschwellwerts der aktuellen Pendelauslenkung aktiviert. Vorzugsweise liegt der Auslöseschwellwert in einem Bereich von 0,1 mm bis 0,8 mm.

Vorzugsweise entspricht der vorgebbare Bewegungsabschnitt dem Betrag nach der zugeordneten, aktuellen Pendelauslenkung. Alternativ kann der vorgebbare Bewegungsabschnitt dem Betrag nach einen Prozentsatz, vorzugsweise im Bereich von 20 % bis 90 %, weiter vorzugsweise in einem Bereich von 30 % bis 60 %, oder dem Betrag nach ein Vielfaches, vorzugsweise ein 1,1-faches bis 3-faches, weiter vorzugsweise ein 1,5faches bis 2-faches, der zugeordneten, aktuellen Pendelauslenkung betragen. Es ist weiterhin vorstellbar, dass die Abstimmung des Betrags des Bewegungsabschnitts in Reaktion auf eine aktuelle Pendelauslenkung über den Ziehprozess hinweg verändert eingestellt werden kann.

Mit anderen Worten ist die Pendelauslenkungsreduzierungsvorrichtung vorzugsweise dazu ausgebildet, über eine gezielte (insbesondere kommunizierende) Ansteuerung ihrer Piezoelementeinheiten über eine Steuereinheit (der Pendelauslenkungsreduzierungsvorrichtung) durch eine gezielte Einstellung eines Bewegungsabschnitts der Umlenkrolle einer aktuellen Pendelauslenkung (in Bezug auf eine Kristallpendelruheachse) des während des Ziehprozesses im Wesentlichen kontinuierlich wachsenden Kristallstabs entgegenzuwirken. Mit anderen Worten wird in Reaktion auf eine aktuelle Pendelauslenkung über eine entsprechende Ansteuerung der Pendelauslenkungsreduzierungsvorrichtung der Umlenkrolle zur Entgegenwirkung - dank der kurzen Reaktionszeiten der Piezoelementmotoren - zeitlich unmittelbar folgend eine Art Gegenbewegung in Form des gezielt einstellbaren, vorgebbaren Bewegungsabschnitts aufgeprägt, um das Orbiting während der Herstellung des Kristallstabs an der Kristallziehvorrichtung zu reduzieren. Dieser Prozess wiederholt sich vorzugsweise kontinuierlich während des Ziehprozesses.

Die Ermittlung der aktuellen Pendelauslenkung des im Wesentlichen kontinuierlich wachsenden Kristallstabs erfolgt insbesondere über eine Ermittlungsvorrichtung umfassend eine Kameravorrichtung an der Kristallziehvorrichtung (auf bekannte Weise).

Die Ansteuerung zur Gegenbewegung erfolgt vorzugsweise mit einem vorgebbaren Algorithmus.

Die Umlenkrolle ist vorzugsweise an dem Deckengehäuse des Seildrehkopfes der Kristallziehvorrichtung über eine Tragkonstruktion mittels Schraubverbindung lösbar befestigt.

### Kurzbeschreibung der Figur

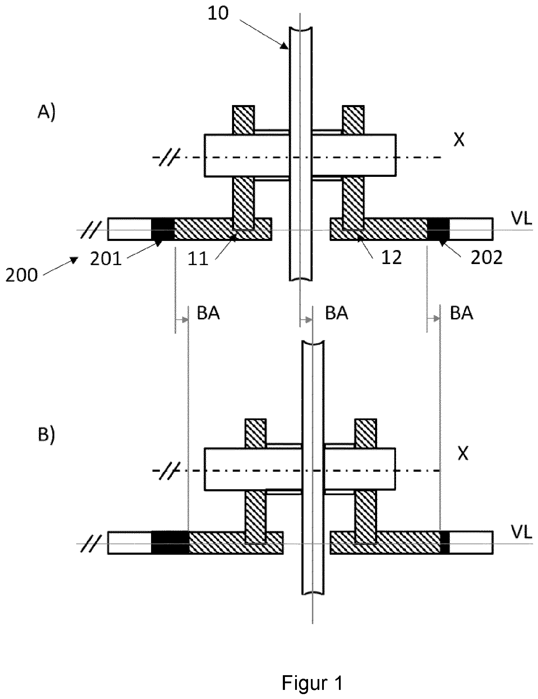

**Figur 1** zeigt eine schematische Darstellung einer Umlenkrolle 10 und ihre Lageraufnahmen 11, 12, welche Piezoelementeinheiten 201, 202 umfassen, in einem Zustand A, der die Umlenkrolle in einer Ruhelage zeigt, und in einem Zustand B, in welchem sich die Umlenkrolle 10 sowie die Piezoelementeinheiten 201, 202 um eine gleichgerichtete Bewegung in Form eines Bewegungsabschnitts BA beabstandet von der Ruhelage zeigen.

### Detaillierte Beschreibung erfindungsgemäßer Ausführungsbeispiele

Im Folgenden und mit Verweis auf Figur 1 wird eine bevorzugte Ausführungsform der erfindungsgemäßen Kristallziehvorrichtung zur Herstellung eines Einkristallstabs unter verminderter Pendelauslenkung während eines Ziehprozesses mittels der erfindungsgemäßen Pendelauslenkungsreduzierungsvorrichtung beschrieben.

Die Kristallziehvorrichtung zur Herstellung eines Einkristallstabs (wobei während eines Ziehprozesses ein im Wesentlichen sukzessiv fortschreitenden Einkristallstababschnitt mit einer einhergehenden im Wesentlichen sukzessiv fortschreitenden zugeordneten Einkristalllänge aus einer Schmelze zu dem Einkristallstab gezogen wird) umfasst eine Ziehvorrichtung nach Art einer Seilpendelvorrichtung mit einem Seildrehkopf, wobei der Seildrehkopf eine Umlenkrolle 10 umfasst. Die Kristallziehvorrichtung entspricht dem grundsätzlichen Aufbau nach (abgesehen von der speziellen Ausführung der Vorrichtung zur Pendelauslenkungsreduzierung) einer konventionellen Kristallziehvorrichtung und ist daher dazu ausgebildet, während eines Ziehprozesses einen im Wesentlichen sukzessiv fortschreitenden Einkristallstababschnitt mit einer einhergehenden im Wesentlichen sukzessiv fortschreitenden zugeordneten Einkristalllänge aus einer Schmelze zu dem Einkristallstab zu ziehen. Hierbei definiert die Kristallziehvorrichtung durch die Umlenkrolle 10 der Ziehvorrichtung einen Pendeldrehpunkt, durch welchen im Wesentlichen entlang einer Höhenachse, eine definierte Kristallpendelruheachse verläuft, um welche sich der sukzessiv fortschreitende Kristallstababschnitt nach Art eines Pendels mit aktuellen Pendelauslenkungen bewegt.

Die Kristallziehvorrichtung weist eine Pendelauslenkungsreduzierungsvorrichtung 200 auf, welche zwei Piezoelementeinheiten 201, 202 und eine Steuereinheit umfasst, wobei die Pendelauslenkungsreduzierungsvorrichtung 200 dazu ausgebildet ist und derart mit der Umlenkrolle 10 des Seildrehkopfs während des Ziehprozesses zusammenwirkt, dass über eine gezielte, kommunizierende Ansteuerung der Piezoelementeinheiten 201, 202 über die Steuereinheit unter Ausnutzung des bekannten Piezoeffekts zur gezielten Einstellung eines Bewegungsabschnitts BA (schematisch angedeutet in Figur 1) der Umlenkrolle 10 einer aktuellen Pendelauslenkung, vorzugsweise in Bezug auf die Kristallpendelruheachse, des im Wesentlichen kontinuierlich zu einem Kristallstab wachsenden Kristallstababschnitts entgegengewirkt wird.

Die Pendelauslenkungsreduzierungsvorrichtung 200 ist dazu ausgebildet und, wie in Figur 1 schematisch dargestellt, derart in Bezug zur Umlenkrolle 10 angeordnet, konkret zu den Lageraufnahmen 11, 12 der Umlenkrolle 10, dass über die kommunizierende Ansteuerung über die Steuereinheit unter Ausnutzung des Piezoeffekts die Bewegung der Umlenkrolle 10 in Form des Bewegungsabschnitts BA über den Antrieb der Piezoelementeinheiten 201, 202 vorgenommen wird. Mit anderen Worten sind die Piezoelementeinheiten 201, 202 dazu ausgebildet, durch eine Ansteuerung als Motoreinheiten zu wirken, wobei sie als Kleinmotoren ausgeführt sind, um beim Zusammenwirken mit der Umlenkrolle 10 der unter Ausnutzung des Piezoeffekts die Bewegung der Umlenkrolle 10 in Form des Bewegungsabschnitts BA hervorzurufen. Die Piezoelementeinheiten 201, 202 sind hierbei im Wesentlichen symmetrisch zu beiden Seiten der Umlenkrolle 10 beabstandet, jeweils in einer der Lageraufnahmen 11, 12 der Umlenkrolle 10, angeordnet, wobei dann die Bewegung der Umlenkrolle 10 in Form des Bewegungsabschnitts BA aus der gleichgerichteten Bewegung der Piezoelementeinheiten 201, 202 resultiert.

Figur 1 zeigt eine höchst schematische Darstellung der Umlenkrolle 10 und ihre Lageraufnahmen 11, 12, welche Piezoelementeinheiten 201, 202 umfassen in einem Zustand A, der die Umlenkrolle in einer Ruhelage zeigt, und in einem Zustand B, in welchem sich die Umlenkrolle 10 sowie die Piezoelementeinheiten 201, 202 um eine gleichgerichtete Bewegung in Form eines Bewegungsabschnitts BA verschieblich in Bezug auf die Ruhelage zeigen. In der Ruhelage fällt die Höhenachse der Umlenkrolle im Wesentlichen mit der Kristallpendelruheachse zusammen. Die Piezoelementeinheiten 201, 202 sind in den Lageraufnahmen 11, 12 der Umlenkrolle 10 angeordnet. Die Umlenkrolle 10 ist über eine Tragkonstruktion, welche die Lageraufnahem umfasst, auf bekannte Weise und nicht in Figur 1 dargestellt, an dem Deckengehäuse des Seildrehkopfes mittels Schraubverbindung lösbar befestigt.

Die Umlenkrolle 10 und die Pendelauslenkungsreduzierungsvorrichtung 200 sind weiterhin dazu ausgebildet, während des Ziehprozesses in Reaktion auf eine aktuelle Pendelauslenkung eines aktuellen Kristallstababschnitts und in Abhängigkeit der Höhe der aktuellen Pendelauslenkung des aktuellen Kristallstababschnitts,, bei Überschreiten eines vorgebbaren Auslöseschwellwertes (hier 0,2 mm), die Umlenkrolle 10 in einer Richtung entlang einer Achse X, welche mit der Umlenkrollenrotationsachse zusammenfällt, die Bewegung in Form des Bewegungsabschnitts BA mit einem maximalen Betrag von 1,5 mm (ausgehend von der Ruhelage der Umlenkrolle 10) erfährt. Hierbei sind die Piezoelementeinheiten 201, 202 derart in den Lageraufnahmen 11, 12 der Umlenkrolle 10 angeordnet, dass eine gedachte Verbindungslinie (VL) der Schwerpunkte der beiden Piezoelementeinheiten 201, 202 parallel zu der Achse X verläuft. Die Bewegungsachse, auf der die eindimensionale Bewegung der Umlenkrolle 10 zur Reduzierung der Pendelauslenkung verläuft, ist somit eindeutig fix vorgegeben und reduziert somit auf einfache Weise, jedoch auf ausreichend effektive Weise und richtungsunabhängig von der aktuellen Pendelauslenkung die weitere Pendelauslenkung im Ziehprozess.

Der vorgebbare Bewegungsabschnitt BA entspricht im vorliegenden Ausführungsbeispiel dem Betrag nach der zugeordneten, aktuellen Pendelauslenkung. Die Ermittlung der aktuellen Pendelauslenkung des im Wesentlichen kontinuierlich wachsenden Kristallstabs erfolgt über eine Ermittlungsvorrichtung umfassend eine Kameravorrichtung an der Kristallziehvorrichtung, auf bekannte Weise.

## Patentansprüche

1. Pendelauslenkungsreduzierungsvorrichtung (200) umfassend zwei Piezoelementeinheiten (201, 202) und eine Steuereinheit, welche dazu ausgebildet sind und derart mit einer Umlenkrolle (10) eines Seildrehkopfs einer Kristallziehvorrichtung während eines Ziehprozesses zusammenwirken, dass über eine gezielte, kommunizierende Ansteuerung der Piezoelementeinheiten (201, 202) über die Steuereinheit unter Ausnutzung des Piezoeffekts zur gezielten Einstellung eines Bewegungsabschnitts der Umlenkrolle (10) einer aktuellen Pendelauslenkung, vorzugsweise in Bezug auf eine Kristallpendelruheachse, des im Wesentlichen kontinuierlich zu einem Kristallstab wachsenden Kristallstababschnitts entgegengewirkt wird.

2. Pendelauslenkungsreduzierungsvorrichtung nach Anspruch 1, wobei die Piezoelementeinheiten (201, 202) dazu ausgebildet sind, beim Zusammenwirken mit einer Kristallziehvorrichtung für die Reduzierung von Pendelauslenkungen an der Kristallziehvorrichtung durch eine Ansteuerung als Motoreinheiten zu wirken, wobei sie als Kleinmotoren ausgeführt sind, welche dazu ausgebildet sind, den Piezoeffekt zur Erzeugung einer Bewegung zu nutzen.

3. Pendelauslenkungsreduzierungsvorrichtung nach Anspruch 1 oder 2, wobei die Piezoelementeinheiten dazu ausgebildet sind, als Lagereinheiten und/oder Führungseinheiten beim Zusammenwirken mit einer Umlenkrolle (10), insbesondere mit Lageraufnahmen (11, 12) einer Umlenkrolle (10), zu wirken.

4. Kristallziehvorrichtung zur Herstellung eines Einkristallstabs, umfassend eine Ziehvorrichtung nach Art einer Seilpendelvorrichtung mit einem Seildrehkopf, wobei der Seildrehkopf eine Umlenkrolle (10) umfasst, wobei
• die Kristallziehvorrichtung dazu ausgebildet ist, während wenigstens eines Ziehprozesses einen im Wesentlichen sukzessiv fortschreitenden Einkristallstababschnitt mit einer einhergehenden im Wesentlichen sukzessiv fortschreitenden zugeordneten Einkristalllänge aus einer Schmelze zu dem Einkristallstab zu ziehen, wobei
• die Kristallziehvorrichtung, vorzugsweise durch die Ziehvorrichtung, einen Pendeldrehpunkt definiert, durch welchen im Wesentlichen entlang einer Höhenachse, eine definierte Kristallpendelruheachse verläuft, **dadurch gekennzeichnet, dass**
• die Kristallziehvorrichtung weiterhin eine Pendelauslenkungsreduzierungsvorrichtung (200) aufweist, welche zwei Piezoelementeinheiten (201, 202) und eine Steuereinheit umfasst, wobei die Pendelauslenkungsreduzierungsvorrichtung (200) dazu ausgebildet ist und derart mit der Umlenkrolle (10) des Seildrehkopfs während eines Ziehprozesses zusammenwirkt, dass über eine gezielte, kommunizierende Ansteuerung der Piezoelementeinheiten (201, 202) über die Steuereinheit unter Ausnutzung des Piezoeffekts zur gezielten Einstellung eines Bewegungsabschnitts (BA) der Umlenkrolle (10) einer aktuellen Pendelauslenkung, vorzugsweise in Bezug auf die Kristallpendelruheachse, des im Wesentlichen kontinuierlich zu einem Kristallstab wachsenden Kristallstababschnitts entgegengewirkt wird.

5. Kristallziehvorrichtung nach Anspruch 4, wobei die
Pendelauslenkungsreduzierungsvorrichtung (200) dazu ausgebildet ist und derart angeordnet ist in Bezug zur Umlenkrolle(10), insbesondere zu den Lageraufnahmen (11, 12) der Umlenkrolle (10), dass über eine kommunizierende Ansteuerung über die Steuereinheit unter Ausnutzung des Piezoeffekts die Bewegung der Umlenkrolle (10) in Form des Bewegungsabschnitts (BA) über den Antrieb der Piezoelementeinheiten (201, 202) vorgenommen wird.

6. Kristallziehvorrichtung nach Anspruch 5, wobei die Piezoelementeinheiten (201, 202) im Wesentlichen symmetrisch zu beiden Seiten der Umlenkrolle (10) beabstandet, jeweils in einer Lageraufnahme (11, 12) der Umlenkrolle (10), angeordnet sind, wobei
die Bewegung der Umlenkrolle (10) in Form des Bewegungsabschnitts (BA) aus der gleichgerichteten Bewegung der Piezoelementeinheiten (201, 202) der Umlenkrolle (10) resultiert.

7. Kristallziehvorrichtung nach einem der Ansprüche 4 bis 6, wobei die Piezoelementeinheiten (201, 202) dazu ausgebildet sind, durch eine Ansteuerung als Motoreinheiten zu wirken, wobei sie als Kleinmotoren ausgeführt sind, welche dazu ausgebildet sind, beim Zusammenwirken mit der Umlenkrolle (10) der Kristallziehvorrichtung unter Ausnutzung des Piezoeffekts die Bewegung der Umlenkrolle (10) in Form des Bewegungsabschnitts (BA) hervorzurufen.

8. Kristallziehvorrichtung nach einem der Ansprüche 4 bis 7, wobei die Umlenkrolle (10) und die Pendelauslenkungsreduzierungsvorrichtung (200) dazu ausgebildet sind, dass während des Ziehprozesses in Reaktion auf eine aktuelle Pendelauslenkung eines aktuellen Kristallstababschnitts, und insbesondere in Abhängigkeit der Höhe der aktuellen Pendelauslenkung des aktuellen Kristallstababschnitts, insbesondere bei Überschreiten eines vorgebbaren Auslöseschwellwertes, die Umlenkrolle (10) in einer Richtung entlang einer Achse X, welche mit der Umlenkrollenrotationsachse zusammenfällt, eine Bewegung in Form des Bewegungsabschnitts (BA) mit einem maximalen Betrag eines Bewegungsabschnitts von 1,5 mm, vorzugsweise 1,0 mm, ausgehend von einer Ruhelage der Umlenkrolle (10), erfährt.

9. Kristallziehvorrichtung nach einem der Ansprüche 4 bis 8, wobei die Piezoelementeinheiten (201, 202) derart in den Lageraufnahmen (11, 12) der Umlenkrolle (10) angeordnet sind, dass eine gedachte Verbindungslinie der Schwerpunkte der beiden Piezoelementeinheiten (201, 202) parallel zu einer Achse X verläuft, welche mit der Umlenkrollenrotationsachse zusammenfällt.

10. Verfahren zur Herstellung eines Einkristallstabs an einer Kristallziehvorrichtung nach einem der Ansprüche 4 bis 9 unter verminderter Pendelauslenkung während eines Ziehprozesses mittels einer Pendelauslenkungsreduzierungsvorrichtung (200) nach einem der Ansprüche 1 bis 3, wobei während des Ziehprozesses ein im Wesentlichen sukzessiv fortschreitenden Einkristallstababschnitt mit einer einhergehenden im Wesentlichen sukzessiv fortschreitenden zugeordneten Einkristalllänge aus einer Schmelze zu dem Einkristallstab gezogen wird.

11. Verfahren zur Herstellung einer Scheibe aus Halbleitermaterial aus einem Einkristallstab, welcher unter verminderter Pendelauslenkung nach einem Verfahren zur Herstellung eines Einkristallstabs nach Anspruch 10 an einer Kristallziehvorrichtung nach einem der Ansprüche 4 bis 9 hergestellt wurde, wobei ausgehend von dem Ende des Verfahrens zur Herstellung des Einkristallstabs wenigstens folgende Schritte folgen:
• Sägen des Einkristallstabs in dünne Scheiben,
• Chemische und/oder mechanische Weiterbehandlung wenigstens einer der dünnen Scheiben aus Halbmaterial, wobei die Weiterbehandlung wenigstens einen Weiterbehandlungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, umfasst.
